# EUROPÄISCHE PATENTSCHRIFT

(11) **EP 3 466 224 B1**
(45) Veröffentlichungstag und Bekanntmachung des Hinweises auf die Patenterteilung: **10.06.2020**
(21) Anmeldenummer: 17716178.3
(22) Anmeldetag: 05.04.2017
(51) Int. Cl.: H05K 5/00

(54) **STANZGITTERANORDNUNG FÜR EIN GETRIEBESTEUERMODUL MIT DURCH EINE GEKAPSELTE DRAHTBONDVERBINDUNG VERBUNDENEN CU- UND AL-STANZGITTERN**
STAMPED GRID ARRANGEMENT FOR A TRANSMISSION CONTROL MODULE COMPRISING CU AND AL STAMPED GRIDS CONNECTED BY AN ENCAPSULATED WIRE BONDING CONNECTION
ENSEMBLE DE GRILLES ESTAMPÉES POUR MODULE DE COMMANDE DE TRANSMISSION COMPORTANT DES GRILLES ESTAMPÉES EN CU ET AL RELIÉES PAR UNE LIAISON FILAIRE SOUDÉE ENCAPSULÉE

(30) Priorität: 31.05.2016 DE 102016209477
(43) Veröffentlichungstag der Anmeldung: 10.04.2019
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2017/058110
(87) Internationale Veröffentlichungsnummer: WO 2017/207139

(56) Entgegenhaltungen:
- EP-A2- 1 460 688
- DE-A1-102012 213 916
- DE-A1-102013 217 549
- DE-A1-102013 222 855
- DE-A1-102015 219 466
- US-A1- 2008 266 821

## Beschreibung

### Gebiet der Erfindung

Die vorliegende Erfindung betrifft eine Stanzgitteranordnung für ein Getriebesteuermodul. Die Erfindung betrifft ferner ein Getriebesteuermodul mit einer solchen Stanzgitteranordnung sowie ein Verfahren zum Fertigen einer Stanzgitteranordnung.

### Stand der Technik

Getriebesteuermodule werden dazu eingesetzt, Funktionen eines Getriebes in einem Kraftfahrzeug zu steuern. DE 10 2010 030 528 A1 beschreibt ein Beispiel eines eingekapselten Steuerungsmoduls für ein Kraftfahrzeug.

DE 10 2013 222855 A1 beschreibt ein Stanzgitter für ein Getriebesteuermodul, umfassend Kontaktierungszonen, die zu einer direkten elektrischen Verbindung mit der elektrischen Schaltung oder zu einer indirekten elektrischen Verbindung mit der elektrischen Schaltung über ein elektrisches Verbindungselement ausgebildet sind.

Häufig wird ein Getriebesteuermodul im Innern eines Getriebes eingebaut, wo es in Kontakt mit aggressiven Medien, insbesondere heißem Getriebeöl, kommen kann. Das Getriebesteuermodul verfügt dabei über elektrische bzw. elektronische Bauelemente wie zum Beispiel Sensoren, Aktuatoren und/oder Stecker sowie über eine Getriebesteuereinheit (TCU-Transmission Control Unit). Um diese Bauelemente elektrisch miteinander zu verbinden, wird eine Verbindungstechnik beispielsweise unter Verwendung sogenannter Stanzgitter eingesetzt. Ein Stanzgitter verfügt dabei über elektrisch leitfähige Leiterbahnen, die beispielsweise aus einem Metallblech gestanzt werden.

Zur Herstellung eines Stanzgitters wird ein Metallblech in der Regel Stanzprozessen sowie einem meist zweistufigen Kunststoffumspritzungsprozess unterzogen. Dabei werden benachbarte Leiterbahnen zunächst bereichsweise freigestanzt, bleiben jedoch anfänglich noch über Verbindungsstege mechanisch miteinander verbunden. Dann wird in einem ersten Umspritzungsprozess Kunststoff um die freigestanzten Leiterbahnen gespritzt, um diese relativ zueinander positioniert zu halten. Anschließend werden auch die Verbindungsstege zwischen benachbarten Leiterbahnen freigestanzt, bevor dann in einem zweiten Kunststoffumspritzungsprozess die Leiterbahnen bis auf freiliegende Enden vollständig umspritzt werden, um diese insbesondere gegen Metallspäne und aggressive Medien schützen zu können.

Insbesondere wenn die Leiterbahnen des Stanzgitters aus Kupfer oder einer Kupferlegierung bestehen, müssen diese besonders effizient gegen einen Angriff aggressiver Medien geschützt werden, da Kupfer beispielsweise von heißem Getriebeöl an- und aufgelöst werden kann. Oberflächen eines für das Stanzgitter verwendeten Kupferblechs werden daher meist mit speziellen Zinnoberflächen geschützt. Allerdings kann es insbesondere in den Bereichen, in denen die Leiterbahnen freigestanzt werden, dennoch zu freiliegenden Kupferoberflächen kommen. Daher sollten geeignete Vorkehrungen getroffen werden, um zu verhindern, dass aggressive Medien in Kontakt mit solchen freiliegenden Kupferoberflächen kommen.

### Offenbarung der Erfindung

### Vorteile der Erfindung

Ausführungsformen der vorliegenden Erfindung können in vorteilhafter Weise eine Stanzgitteranordnung für ein Getriebesteuermodul ermöglichen, bei der insbesondere korrosionsbedingte Schädigungen durch Kontakt aggressiver Umgebungsmedien mit freiliegenden Kupferoberflächen eines Stanzgitters vermieden werden können. Ferner kann gegebenenfalls eine Stanzgitteranordnung mit geringem Gewicht und/oder einfacher elektrischer Kontaktierbarkeit bereitgestellt werden, welche verhältnismäßig kostengünstig hergestellt werden kann.

Gemäß einem ersten Aspekt der Erfindung wird eine Stanzgitteranordnung für ein Getriebesteuermodul vorgeschlagen. Die Stanzgitteranordnung weist ein erstes Stanzgitter mit aluminiumhaltigen Leiterbahnen und zumindest ein zweites Stanzgitter mit kupferhaltigen Leiterbahnen auf. Die Leiterbahnen des ersten Stanzgitters sind mit Leiterbahnen des zweiten Stanzgitters elektrisch verbunden. Die Stanzgitteranordnung zeichnet sich dadurch aus, dass Leiterbahnen des ersten Stanzgitters mit Leiterbahnen des zweiten Stanzgitters jeweils mittels einer Drahtbondverbindung elektrisch verbunden sind. Dabei sind Verbindungsbereiche, in denen jeweils eine aluminiumhaltige Leiterbahn des ersten Stanzgitters mit einer kupferhaltigen Leiterbahn des zweiten Stanzgitters mittels einer der Drahtbondverbindungen verbunden ist, mittels einer Vergussmasse hermetisch dicht verkapselt.

Gemäß einem zweiten Aspekt der Erfindung wird ein Getriebesteuermodul vorgeschlagen, welches eine Stanzgitteranordnung gemäß einer Ausführungsform des ersten Aspekts der Erfindung aufweist.

Gemäß einem dritten Aspekt der Erfindung wird ein Verfahren zum Fertigen einer Stanzgitteranordnung für ein Getriebesteuermodul, insbesondere einer Stanzgitteranordnung gemäß einer Ausführungsform des ersten Aspekts der Erfindung, vorgeschlagen. Das Verfahren weist ein Bereitstellen eines ersten Stanzgitters mit aluminiumhaltigen Leiterbahnen und eines zweiten Stanzgitters mit kupferhaltigen Leiterbahnen, ein elektrisches Verbinden von Leiterbahnen des ersten Stanzgitters mit Leiterbahnen des zweiten Stanzgitters jeweils durch Drahtbonden und ein hermetisch dichtes Verkapseln von Verbindungsbereichen, in denen jeweils eine aluminiumhaltige Leiterbahn des ersten Stanzgitters mit einer kupferhaltigen Leiterbahn des zweiten Stanzgitters mittels einer der Drahtbondverbindungen verbunden ist, durch Aufbringen einer Vergussmasse auf.

Ideen zu Ausführungsformen der vorliegenden Erfindung können unter anderem als auf den nachfolgend beschriebenen Gedanken und Erkenntnissen beruhend angesehen werden.

Wie einleitend angemerkt, sollte bei für Getriebesteuermodule eingesetzten Stanzgitteranordnungen sichergestellt sein, dass beispielsweise kein Getriebeöl in direkten Kontakt mit freiliegenden Kupferoberflächen gelangen kann.

Es wurde daher vorgeschlagen, Stanzgitter statt aus kupferhaltigen, das heißt aus Kupfer oder einer Kupferlegierung bestehenden Blechen, aus aluminiumhaltigen, das heißt aus Aluminium oder einer Aluminiumlegierung bestehenden Blechen auszustanzen. Aluminium ist im Allgemeinen resistent gegen aggressive Medien, insbesondere gegen Getriebeöl, so dass Oberflächen aluminiumhaltiger Leiterbahnen eines Stanzgitters im Allgemeinen nicht durch spezielle Designmerkmale und/oder Prozessführungen gegen einen Angriff solcher Medien geschützt werden brauchen. Auch Kosten und/oder Gewicht eines Stanzgitters können durch einen Wechsel von Kupfer auf Aluminium reduziert werden.

Allerdings kann es notwendig sein, zumindest an Enden eines Aluminiumstanzgitters noch aus Kupfer bestehende Bereiche vorzusehen. Dies kann unter anderem dadurch bedingt sein, dass Stanzgitter häufig nicht nur für Punkt-zu-Punkt-Verbindungen zwischen Aluminiumanschlussstellen verwendet werden, sondern ein Ende eines Stanzgitters auch als Stecker-Pin verwendet werden kann, beispielsweise mit einer entsprechenden Umspritzung in Steckerform. Stecker-Pins aus Aluminium können jedoch einen Nachteil dahingehend aufweisen, dass sie beispielsweise aufgrund einer Oxidschichtbildung schlechte Steckerpartner sind. Ferner kann es außerdem notwendig sein, andere Bauteile an einem Stanzgitter zu befestigen, die selbst Kupfer-Pins statt Aluminium-Pins aufweisen.

Es wurde daher nach einer Lösung gesucht, an Enden eines Aluminiumstanzgitters kurze Kupfer-Pins anzubringen, insbesondere um das Stanzgitter einfach von außen her elektrisch kontaktieren zu können.

Zu diesem Zweck wurden fertig walzplattierte Kombibleche vorgeschlagen. Diese sind jedoch teuer und haben im Regelfall eine fixe geometrische Aufteilung von Ausgangsplatten oder Streifen, die zu Stanzgittern geformt und gestanzt werden.

Wie weiter unten genauer beschrieben, wurden daher alternativ Stanzgitteranordnungen vorgeschlagen, bei denen ein Aluminiumstanzgitter mit einem Kupferstanzgitter verbunden wurde und die Kombination beider Stanzgitter dann umspritzt wurde. Leiterbahnen des Aluminiumstanzgitters wurden dabei mit Leiterbahnen des Kupferstanzgitters lokal verschweißt und dann die miteinander verschweißten Stanzgitter gemeinsam in eine Kunststoffumspritzungsmasse eingegossen. Die Kunststoffumspritzungsmasse besteht dabei meist aus Polyamid, beispielsweise PA66.

Allerdings wurde beobachtet, dass eine solche Kunststoffumspritzung beispielsweise aufgrund thermisch bedingter mechanischer Spannungen lokale Undichtigkeiten bekommen kann. Getriebeöl kann dann an Bereiche der in der Kunststoffumspritzung aufgenommenen Stanzgitter gelangen.

Dies kann insbesondere dann schädigend wirken, wenn Getriebeöl in Kontakt mit einem Bereich kommt, in dem eine aluminiumhaltige Leiterbahn direkt an eine kupferhaltige Leiterbahn angrenzt. Da Aluminium und Kupfer in der elektrochemischen Spannungsreihe weit auseinanderliegen, kann es aufgrund des wie ein Elektrolyt wirkenden Getriebeöls oder anderer eindringender Medien wie Wasser in einem Verbindungsbereich zu starken elektrochemischen Reaktionen kommen. Das in diesem Fall unedlere Aluminium kann dabei chemisch angegriffen werden bzw. sich korrosiv auflösen.

Außerdem wurde erkannt, dass ein direktes Verschweißen oder Verlöten aluminiumhaltiger Leiterbahnen mit kupferhaltigen Leiterbahnen meist nur technisch aufwendig umgesetzt werden kann.

Es wird daher vorgeschlagen, ähnlich wie im oben beschriebenen Ansatz, eine Stanzgitteranordnung mit zwei verschiedenen Stanzgittern vorzusehen. Aus Aluminium oder einer Aluminiumlegierung bestehende Leiterbahnen eines ersten Stanzgitters sollen dabei mit aus Kupfer oder einer Kupferlegierung bestehenden Leiterbahnen eines zweiten Stanzgitters durch lokal vorzusehende Drahtbondverbindungen verbunden werden. Der Begriff Drahtbondverbindung ist dabei dahingehend zu verstehen, dass ein aus einem Metall wie beispielsweise Kupfer oder Aluminium bestehender Draht oder ein entsprechendes Bändchen mittels geeigneter Bondprozesse mit einer Seite an der aluminiumhaltigen Leiterbahn und mit der anderen Seite an der kupferhaltigen Leiterbahn angebondet wird. Die Drahtbondverbindung führt dabei zu einer elektrischen Verbindung zwischen beiden Leiterbahnen. Mit anderen Worten soll die elektrische Verbindung zwischen Leiterbahnen des ersten Stanzgitters und Leiterbahnen des zweiten Stanzgitters nicht oder zumindest nicht mehr vornehmlich durch lokale Verschweißungen, sondern stattdessen durch die lokal vorzusehenden Drahtbondverbindungen bewirkt werden.

Um die Verbindungsbereiche, in denen jeweils eine aluminiumhaltige Leiterbahn des ersten Stanzgitters mit einer kupferhaltigen Leiterbahn des zweiten Stanzgitters mittels einer der Drahtbondverbindungen verbunden ist, gegen einen Angriff aggressiver Medien zu schützen, werden diese Verbindungsbereiche mittels einer Vergussmasse hermetisch dicht verkapselt. Unter einer hermetisch dichten Verkapselung soll dabei verstanden werden, dass die Vergussmasse zumindest diejenigen Bereiche der aluminiumhaltigen Leiterbahnen und kupferhaltigen Leiterbahnen, in denen diese über die jeweiligen Drahtbondverbindungen miteinander verbunden sind, derart vollständig bedeckt bzw. umschließt, dass keine fluiden, das heißt flüssigen oder gasförmigen, Medien mehr an die Oberflächen dieser aluminium- und kupferhaltigen Leiterbahnen gelangen können. Mithilfe der lokal auf die Verbindungsbereiche aufgebrachten Vergussmasse können die Leiterbahnen des ersten und des zweiten Stanzgitters zumindest in diesen Verbindungsbereichen zuverlässig gegen einen Angriff von beispielsweise Getriebeöl geschützt werden.

Gemäß einer Ausführungsform ist die Vergussmasse eine Epoxidharzmasse, eine Polyurethanmasse oder eine Acrylatmasse.

Im Gegensatz zu dem herkömmlich als Kunststoffumspritzungsmasse für Stanzgitter eingesetzten Polyamid weist Epoxidharz oder auch PU oder Acrylate einen verhältnismäßig kleinen thermischen Ausdehnungskoeffizienten (CTE - Coefficient of Thermal Expansion) auf. Der CTE von Epoxidharz kann z.B. typischerweise im Bereich von 15 bis 23 ppm/K liegen. Der CTE der Vergussmasse ist damit sehr ähnlich dem CTE der für die beiden Stanzgitter sowie für die Drahtbondverbindung eingesetzten Materialien. Somit kommt es bei Temperaturschwankungen allenfalls zu geringen thermomechanischen Spannungen. Eine Gefahr, dass es aufgrund von Temperaturänderungen zu Undichtigkeiten in der durch die Vergussmasse bewirkten Verkapselung der Verbindungsbereiche kommt, kann somit gering gehalten werden.

Gemäß einer Ausführungsform umschließt die Vergussmasse die Drahtbondverbindungen vollständig.

Mit anderen Worten sollte die Vergussmasse in den Verbindungsbereichen vorzugsweise nicht lediglich die Oberflächen der angrenzenden aluminium- und kupferhaltigen Leiterbahnen bedecken und diese damit hermetisch dicht verkapseln, sondern auch die dort an den Leiterbahnen angebrachten Drahtbondverbindungen vollständig umschließen. Damit werden einerseits auch die Drahtbondverbindungen hermetisch dicht verkapselt, andererseits werden diese Drahtbondverbindungen auch mechanisch durch die sie umschließende Vergussmasse geschützt.

Gemäß einer Ausführungsform sind die kupferhaltigen Leiterbahnen des zweiten Stanzgitters zumindest außerhalb der Verbindungsbereiche vollständig mit einer korrosionshemmenden Schicht, insbesondere einer Zinnschicht, beschichtet.

Mit anderen Worten sollten vorzugsweise die Leiterbahnen des zweiten Stanzgitters überall dort, wo diese nicht durch Vergussmasse in den Verbindungsbereichen hermetisch dicht verkapselt sind, oberflächlich mit einer korrosionshemmenden Schicht versehen sein. Die korrosionshemmende Schicht kann insbesondere eine Metallschicht, vorzugsweise eine Zinnschicht, sein. Die korrosionshemmende Schicht kann sehr dünn sein, beispielsweise eine Dicke von zwischen 10nm und 100µm aufweisen. Die korrosionshemmende Schicht kann auf das ungestanzte oder bereits teilweise oder vollständig gestanzte Blech, aus dem das zweite Stanzgitter gefertigt wird, aufgebracht werden. Beispielsweise kann die korrosionshemmende Schicht galvanisch aufgebracht werden. Dabei kann die Prozessführung zur Herstellung des zweiten Stanzgitters, das heißt insbesondere die Stanzprozesse, derart angepasst werden, dass eine zuvor oberflächlich aufgebrachte korrosionshemmende Schicht beim Stanzen allenfalls in den späteren Verbindungsbereichen, nicht jedoch außerhalb dieser Verbindungsbereiche, lokal beschädigt wird. Die Verbindungsbereiche werden jedoch durch die Vergussmasse hermetisch dicht gekapselt. Die kupferhaltigen Leiterbahnen sind somit überall gegen einen Angriff aggressiver Medien geschützt, einerseits durch die in den Verbindungsbereichen vorgesehene hermetische Verkapselung mittels der Vergussmasse, andererseits durch die in den anderen Bereichen vorgesehene korrosionshemmende Schicht.

Gemäß einer Ausführungsform ist ein Abstand zwischen nicht von der Vergussmasse bedeckten freiliegenden Bereichen von aluminiumhaltigen Leiterbahnen des ersten Stanzgitters und nicht von der Vergussmasse bedeckten freiliegenden Bereichen von kupferhaltigen Leiterbahnen des zweiten Stanzgitters wenigstens 0,5 cm, vorzugsweise wenigstens 0,8 cm. Dies entspricht in etwa dem 2-fachen einer Stanzgitterblechdicke unter Hinzunahme, wenn sich die Stanzgitter überlappen, der Länge des Überlappungsbereichs. Insbesondere sollte ein Abstand zwischen nicht von der Vergussmasse bedeckten freiliegenden Bereichen der aluminiumhaltigen Leiterbahnen und weder von der Vergussmasse bedeckten noch mit einer korrosionshemmenden Schicht beschichteten ungeschützten Bereichen von kupferhaltigen Leiterbahnen vorzugsweise wenigstens 0,5 cm, vorzugsweise wenigstens 0,8cm , betragen. Mit anderen Worten sollten die von der Vergussmasse hermetisch dicht verkapselten Verbindungsbereiche derart groß bemessen ausgebildet werden, dass freiliegende und insbesondere nicht durch eine korrosionshemmende Schicht geschützte Bereiche der kupferhaltigen Leiterbahnen des zweiten Stanzgitters einerseits und der aluminiumhaltigen Leiterbahnen des ersten Stanzgitters andererseits möglichst ausreichend weit voneinander beabstandet liegen, dass es zu keiner wesentlichen lonenwanderung in einem diese Bereiche gemeinsam bedeckenden Elektrolyten, insbesondere in Getriebeöl, kommen kann. Anders ausgedrückt sollen freiliegende bzw. ungeschützte Bereiche der beiden Stanzgitter durch dazwischenliegende verkapselte Verbindungsbereiche derart weit voneinander getrennt sein, dass Ionen von einem freiliegenden Bereich einer kupferhaltigen Leiterbahn kaum noch bis zu einem freiliegenden Bereich einer aluminiumhaltigen Leiterbahn gelangen können. Eine elektrochemische Korrosion dieser Bereiche bei Kontakt mit elektrolytisch wirkenden Medien kann somit aufgrund des ausreichend groß bemessenen dicht verkapselten Verbindungsbereichs weitgehend vermieden werden.

Gemäß einer Ausführungsform sollen das erste und das zweite Stanzgitter der Stanzgitteranordnung derart ausgebildet und angeordnet sein, dass eine aluminiumhaltige Leiterbahn des ersten Stanzgitters von einer kupferhaltigen Leiterbahn des zweiten Stanzgitters in dem Verbindungsbereich über einen Spalt beabstandet ist. Der Spalt soll dabei mit Vergussmasse gefüllt sein.

Mit anderen Worten sollen die Leiterbahnen des ersten Stanzgitters vorzugsweise nicht in direkt anliegendem Kontakt mit den Leiterbahnen des zweiten Stanzgitters stehen, sondern mit diesen elektrisch lediglich durch die Drahtbondverbindungen verbunden sein. Ein zwischen Enden der Leiterbahnen des ersten Stanzgitters und Enden des zweiten Stanzgitters verbleibender Spalt sollte möglichst vollständig mit Vergussmasse gefüllt sein. Die Vergussmasse füllt dabei nicht nur den Spalt, sondern bedeckt auch angrenzende Bereiche der aluminium- und kupferhaltigen Leiterbahnen. Auf diese Weise kann eine besonders effiziente hermetisch dichte Verkapselung in den Verbindungsbereichen erreicht werden. Außerdem kann ein lonenfluss zwischen den aluminiumhaltigen und den kupferhaltigen Leiterbahnen und damit elektrochemische Korrosion verhindert werden

Gemäß einer Ausführungsform sind das erste und/oder das zweite Stanzgitter zumindest bereichsweise mit einer Kunststoffumspritzungsmasse, insbesondere mit Polyamid, umspritzt.

Mit anderen Worten sollen Teile des ersten und/oder des zweiten Stanzgitters, ähnlich wie bei herkömmlichen Stanzgittern, separat in eine Kunststoffumspritzungsmasse eingegossen sein. Die Kunststoffumspritzungsmasse bedeckt dabei jeweils Teile der aluminium- bzw. kupferhaltigen Leiterbahnen in Bereichen außerhalb der Verbindungsbereiche. Anders ausgedrückt, können die beiden Stanzgitter ähnlich wie herkömmliche Stanzgitter in Polyamid eingegossen sein, wobei jedoch beispielsweise Enden jeweiliger Leiterbahnen frei bleiben, so dass die beiden Stanzgitter an diesen Enden mit ihren Leiterbahnen über jeweilige Drahtbondverbindungen verbunden werden können und dann die dortigen Verbindungsbereiche lokal mittels einer Vergussmasse hermetisch dicht verkapselt werden können. Die Kunststoffumspritzungsmasse unterscheidet sich dabei vorzugsweise von der Vergussmasse. Insbesondere sollte die Vergussmasse vorzugsweise einen wesentlich geringeren CTE aufweisen als die Kunststoffumspritzungsmasse.

In einer vorteilhaften Ausgestaltung der vorangehend beschriebenen Ausführungsform steht die Kunststoffumspritzungsmasse mit dem jeweiligen Stanzgitter in formschlüssigem Eingriff.

Mit anderen Worten bedeckt die Kunststoffumspritzungsmasse das jeweilige Stanzgitter vorzugsweise nicht nur oberflächlich, sondern greift beispielsweise in Öffnungen innerhalb des jeweiligen Stanzgitters ein und kann sich somit quasi in dem jeweiligen Stanzgitter "verkrallen". Aufgrund einer solchen "Verkrallung" kann die Kunststoffumspritzungsmasse mechanisch fest an dem jeweiligen Stanzgitter gehalten sein, so dass es auch beispielsweise bei thermisch bedingten Längenänderungen zu keinen gefährdenden Relativbewegungen zwischen dem Stanzgitter einerseits und der umgebenden Kunststoffumspritzungsmasse kommt.

Gemäß einer Ausführungsform des hierin vorgeschlagenen Herstellungsverfahrens kann die Vergussmasse auf die Verbindungsbereiche durch Dispensen, Vergießen, Spritzen oder Molden aufgebracht werden. Dabei kann die Vergussmasse vorzugsweise ausreichend dünnflüssig oder viskos sein, so dass diese sich an die Oberflächen der Leiterbahnen in den Verbindungsbereichen anschmiegt und dabei vorzugsweise auch die dort befindlichen Drahtbondverbindungen vollständig umschließt.

Es wird darauf hingewiesen, dass einige der möglichen Merkmale und Vorteile der Erfindung hierin teilweise mit Bezug auf eine Stanzgitteranordnung und teilweise mit Bezug auf ein Verfahren zum Fertigen einer Stanzgitteranordnung beschrieben sind. Ein Fachmann erkennt, dass die Merkmale in geeigneter Weise kombiniert, übertragen, angepasst und/oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1 zeigt eine Draufsicht auf ein Getriebesteuermodul mit einer erfindungsgemäßen Stanzgitteranordnung.
Fig. 2 zeigt eine Schnittansicht durch eine herkömmliche Stanzgitteranordnung.
Fig. 3 zeigt eine Schnittansicht durch eine Stanzgitteranordnung gemäß einer Ausführungsform der vorliegenden Erfindung.
Fig. 4 zeigt eine Schnittansicht durch eine Stanzgitteranordnung gemäß einer weiteren Ausführungsform der vorliegenden Erfindung.
Fig. 5 zeigt eine Schnittansicht durch eine Stanzgitteranordnung gemäß noch einer weiteren Ausführungsform der vorliegenden Erfindung.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

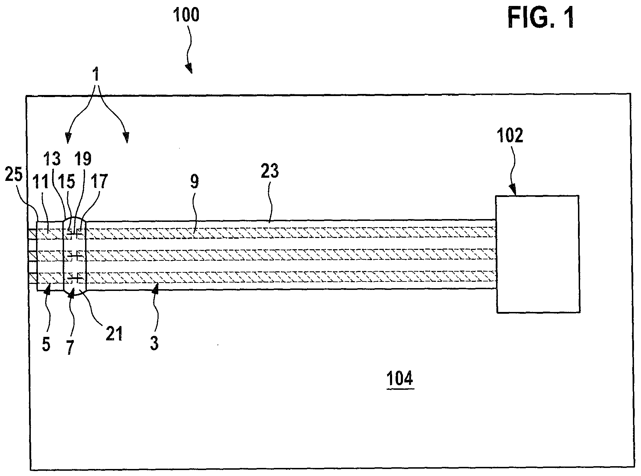

Fig. 1 zeigt ein Beispiel eines Getriebesteuermoduls 100 mit einer Stanzgitteranordnung 1 gemäß einer Ausführungsform der vorliegenden Erfindung. Das Getriebesteuermodul 100 weist elektrische oder elektronische Bauelemente auf. Beispielhaft hierfür ist eine TCU 102 dargestellt. Die Bauelemente können zur mechanischen Stabilisierung und/oder zur Wärmeabfuhr an einem Substrat 104 gehalten sein. Die Stanzgitteranordnung 1 dient dazu, die Bauelemente wie beispielsweise die TCU 102 elektrisch miteinander bzw. mit von außen zu kontaktierenden Anschlüssen zu verbinden. Herkömmlich kann ein Stanzgitter 3 hierfür mehrere Leiterbahnen 9 aufweisen, die in eine Kunststoffumspritzungsmasse 23 eingebettet sind.

Wie weiter oben beschrieben, kann es vorteilhaft sein, die Stanzgitteranordnung 1 aus zwei verschiedenen Stanzgittern zusammenzusetzen. Ein erstes Stanzgitter 3 kann dabei aluminiumhaltige Leiterbahnen 9 aufweisen, wohingegen ein zweites Stanzgitter 5 kupferhaltige Leiterbahnen 11 aufweisen kann. Die aluminiumhaltigen Leiterbahnen 9 können dabei mit den kupferhaltigen Leiterbahnen 11 elektrisch verbunden sein. Auf diese Weise kann erreicht werden, dass einerseits weite Bereiche der Stanzgitteranordnung 1 mit chemisch resistenten aluminiumhaltigen Leiterbahnen 9 versehen sind, aber insbesondere als elektrische Anschlüsse dienende Bereiche der Stanzgitteranordnung mit elektrisch gut zu kontaktierenden kupferhaltigen Leiterbahnen 11 vorgesehen sein können.

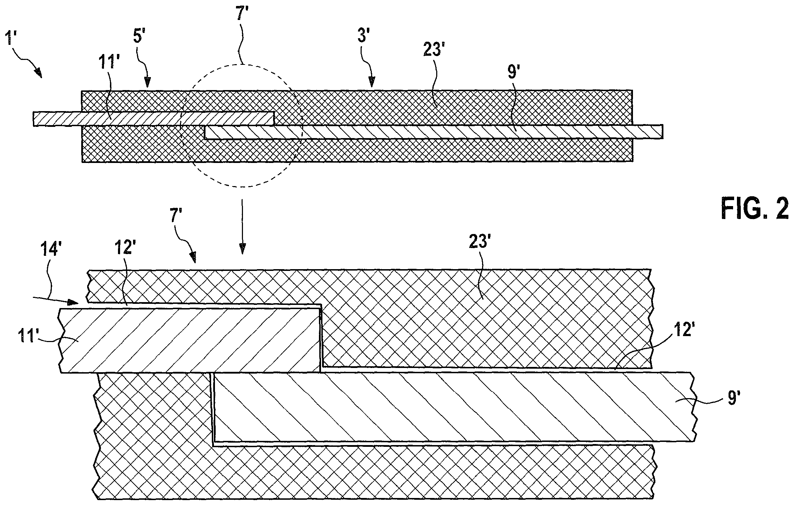

Bevor auf Details einer erfindungsgemäßen Stanzgitteranordnung eingegangen werden soll, werden mit Bezug auf Fig. 2 Eigenschaften einer herkömmlichen Stanzgitteranordnung 1' erläutert. Auch diese herkömmliche Stanzgitteranordnung 1' umfasst ein Aluminiumstanzgitter 3' sowie ein Kupferstanzgitter 5. Die Leiterbahnen 9', 11' beider Stanzgitter 3', 5' sind gemeinsam in eine Kunststoffumspritzungsmasse 23' aus Polyamid eingegossen. Die mittels der Kunststoffumspritzungsmasse 23' gebildete Verkapselung kann dabei in einem zweistufigem Spritzvorgang aufgebaut werden und kann eine geometrisch komplexere Struktur aufweisen, als dies vereinfacht in Fig. 2 dargestellt ist. Enden von Kupfer-Leiterbahnen 11' können dabei mit Enden von Aluminium-Leiterbahnen 9' in einem Verbindungsbereich 7' verschweißt sein und somit elektrisch miteinander verbunden sein.

Wie in der vergrößerten Darstellung des Verbindungsbereichs 7 aus Fig. 2 veranschaulicht, kann es jedoch beispielsweise aufgrund von thermisch bedingten mechanischen Spannungen dazu kommen, dass sich zwischen der Kunststoffumspritzungsmasse 23' und den Leiterbahnen 9', 11' kleine Spalte 12' bilden, durch die beispielsweise Öl, Wasser oder ähnliche fluide Medien eindringen können, wie dies mit dem Pfeil 14' symbolisch veranschaulicht ist. Derartige fluide Medien können dann insbesondere an eine Kontaktstelle, an der kupferhaltige Leiterbahnen 11' mit aluminiumhaltigen Leiterbahnen 9' in mechanischem Kontakt stehen, gelangen. Dort können diese Medien gegebenenfalls als Elektrolyt wirken. Da Kupfer und Aluminium in der elektrochemischen Spannungsreihe weit voneinander entfernt liegen, kann es somit insbesondere an dieser empfindlichen Kontaktstelle zu elektrochemischer Korrosion und letztendlich zur Schädigung des dort gebildeten elektrischen Kontakts kommen.

Zurückkommend auf die in Fig. 1 dargestellte Ausführungsform der hierin vorgeschlagenen Stanzgitteranordnung 1 wird daher vorgesehen, die aluminiumhaltigen Leiterbahnen 9 des ersten Stanzgitters 3 und die kupferhaltigen Leiterbahnen 11 des zweiten Stanzgitters 5 nicht mehr mittels einer gemeinsamen Kunststoffumspritzungsmasse zu umhüllen. Stattdessen sind die Leiterbahnen 9, 11 jedes der Stanzgitter 3, 5 gegebenenfalls in Teilbereichen von einer eigenen Kunststoffumspritzungsmasse 23, 25 umhüllt. Dort, wo die Leiterbahnen 9, 11 der beiden Stanzgitter 3, 5 miteinander elektrisch verbunden werden sollen, ist jedoch keine dieser Kunststoffumspritzungsmassen 23, 25 vorgesehen. Stattdessen liegen dort die aluminiumhaltigen Leiterbahnen 9 und die kupferhaltigen Leiterbahnen 11 zumindest zeitweise während eines Herstellungsprozesses frei.

Enden 17 der aluminiumhaltigen Leiterbahnen 9 und Enden 15 der kupferhaltigen Leiterbahnen 11 werden dann in einem Verbindungsbereich 7 mithilfe von Drahtbondverbindungen 19 elektrisch miteinander kontaktiert.

Anschließend wird der Verbindungsbereich 7 mithilfe einer Vergussmasse 13 hermetisch dicht verkapselt.

Die Vergussmasse 13 kann dabei vorzugsweise aus Epoxidharz bestehen oder zumindest Epoxidharz aufweisen. Alternativ kann Polyurethan oder Acrylat als Vergussmasse 13 eingesetzt werden.

Vorzugsweise kann die Vergussmasse 13 nicht nur die Enden 15, 17 der aluminiumhaltigen und kupferhaltigen Leiterbahnen 9, 11 hermetisch dicht verkapselnd bedecken, sondern auch die Drahtbondverbindungen 15 vollständig umschließen.

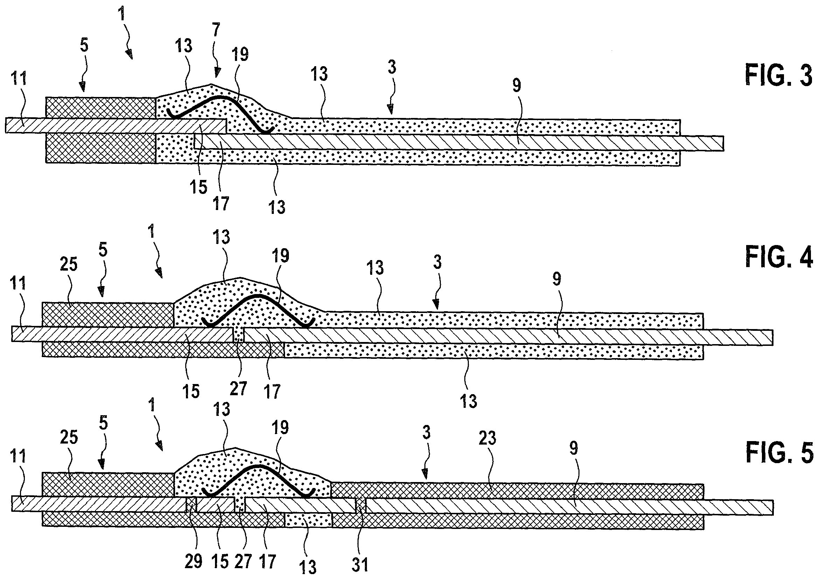

In den Fig. 3, 4 und 5 sind Schnittansichten von drei Ausführungsformen von Stanzgitteranordnungen 1 in einem Bereich in einer Umgebung der Verbindungsbereiche 7 dargestellt.

Bei der in Fig. 3 dargestellten Ausführungsform überlappen die aluminiumhaltigen Leiterbahnen 9 und die kupferhaltigen Leiterbahnen 11 sich mit ihren Enden 15, 17 im Verbindungsbereich 7 geringfügig. Gegebenenfalls können die Leiterbahnen 9, 11 hierbei insbesondere zum Erreichen einer mechanischen Stabilisierung leicht aneinander angeheftet sein.

Eine elektrische Verbindung zwischen den aluminiumhaltigen Leiterbahnen 9 und den kupferhaltigen Leiterbahnen 11 erfolgt jedoch überwiegend über die Drahtbondverbindung 19. Ein Draht oder Bändchen ist dabei mit einer Seite an dem Ende 15 der kupferhaltigen Leiterbahn 11 und mit einem anderen Ende an dem Ende 17 der aluminiumhaltigen Leiterbahn 9 angebondet. Hierfür können herkömmliche Bondprozesse zum Beispiel mit einem Aluminium-Bond oder einem Kupfer-Bond eingesetzt werden. Im Gegensatz zu einer herkömmlichen Verschweißung der Enden 15, 17 braucht dabei im Regelfall vorab nicht eine Oxidschicht beispielsweise von der aluminiumhaltigen Leiterbahn 9 entfernt werden, zum Beispiel durch Abbeizen. Es brauchen auch keine Sonderprozesse wie Kupfer-Aluminium-Schweißen eingesetzt werden. Stattdessen können Standardprozesse wie Kupfer-Aluminium-Wire-Bonden zum Einsatz kommen.

Nachdem die Drahtbondverbindung 19 hergestellt wurde, wird der Verbindungsbereich 7 großflächig mit Vergussmasse 13 versehen. Während der Fertigung der Stanzgitteranordnung 1 ist die Vergussmasse 13 dabei in einem fließfähigen Zustand und kann auf einen oder mehrere benachbarte Verbindungsbereiche 7 beispielsweise durch Dispensen, Vergießen, Spritzen oder Molden aufgebracht werden. Dabei fließt die Vergussmasse 13 um die Drahtbondverbindung 19 herum und schließt diese mitsamt der von ihr kontaktierten Enden 15, 17 der aluminium- und kupferhaltigen Leiterbahnen 9, 11 hermetisch dicht ein.

Da die Vergussmasse 13 einen ähnlichen Wärmeausdehnungskoeffizienten CTE aufweist wie die Leiterbahnen 9, 11 und die Drahtbondverbindung 19 kann die hierdurch bewirkte hermetische Abdichtung auch bei größeren Temperaturschwankungen ungeschädigt bleiben und somit den Verbindungsbereich 7 zuverlässig gegen ein Eindringen aggressiver fluider Medien schützen.

Bei den in den Fig. 4 und 5 dargestellten Ausführungsformen überlappen sich die aluminiumhaltigen Leiterbahnen 9 und die kupferhaltigen Leiterbahnen 11 nicht. Stattdessen sind diese in Längsrichtung voneinander beabstandet, so dass sich zwischen ihnen ein Spalt 27 ausbildet. Die Vergussmasse 13 füllt dabei auch diesen Spalt 27 aus. Die Vergussmasse 13 kann somit noch effizienter verhindern, dass aggressives Fluid sowohl die aluminiumhaltigen Leiterbahnen 9 als auch die kupferhaltigen Leiterbahnen 11 erreicht und als schädigender Elektrolyt wirken kann.

Bei der in Fig. 5 dargestellten Ausführungsform sind außerdem die an den beiden Stanzgittern 3, 5 vorgesehenen Kunststoffumspritzungsmassen 23, 25 derart ausgebildet, dass sie durch Ausnehmungen 29, 31 in den jeweiligen Leiterbahnen 9, 11 hindurchtreten und somit in einen formschlüssigen Eingriff mit dem jeweiligen Stanzgitter 3, 5 stehen. Die Kunststoffumspritzungsmassen 23, 25 können somit mit den Stanzgittern 3, 5 "verkrallt" sein.

Zur Herstellung einer erfindungsgemäßen Stanzgitteranordnung 1 können zunächst das erste Stanzgitter 3 und das zweite Stanzgitter 5 nahe benachbart zueinander angeordnet werden und gegebenenfalls räumlich fixiert werden, zum Beispiel auf der durch eine der Kunststoffumspritzungsmassen 23, 25 gebildeten Umspritzung eines der Stanzgitter 3, 5. Anschließend werden die aluminiumhaltigen Leiterbahnen 9 und die kupferhaltigen Leiterbahnen 11 der beiden Stanzgitter 3, 5 mit einem Wire- oder Bändchen-Bond in einem herkömmlichen Bondprozess miteinander verbunden, zum Beispiel mit einem AI-Bond oder einem Cu-Bond. Die Bondstellen und deren Umgebung, das heißt die Verbindungsbereiche 7, sowie gegebenenfalls auch eine Weiterführung des ersten Stanzgitters 3 wird mit einer Vergussmasse 13, welche auch als Lack ausgebildet sein kann, durch Dispensen, Vergießen oder Spritzen/Molden geschützt, wobei die Vergussmasse anschließend durch Vernetzen ausgehärtet werden kann. Als Vergussmasse sind neben Epoxidharzen auch PU- oder Acrylate denkbar, solange die Bond-Verbindung vollständig gekapselt wird und bei Temperaturänderungen durch Wärmedehnung keine wesentlichen mechanischen Spannungen induziert werden. Die aufgebrachte Vergussmasse stellt somit in jedem Fall sicher, dass die unmittelbare Verbindungsstelle in den Verbindungsbereichen 7 hermetisch dicht gekapselt ist und auch langfristig dicht bleibt.

Auch wenn das bzw. die Stanzgitter 3, 5 auf einem gemeinsamen Teil wie beispielsweise der Verlängerung der durch die Kunststoffumspritzungsmassen 23, 25 gebildeten Umspritzung aufliegen (wie in Fig. 4 und Fig. 5 dargestellt), an dem eine Haftung nicht sichergestellt ist, kann die Vergussmasse 13 im Bereich der Verbindungsbereiche 7, das heißt zwischen den Stirnflächen der beiden Stanzgitter 3, 5, trotzdem für eine Isolation sorgen, da dieser auch auf der Kunststoffauflage haftet, wenn diese mit den Stanzgittern 3, 5 verkrallt ist. Eine solche Verkrallung kann einen Fixpunkt für unterschiedliche Wärmedehnung von Kupfer (CTE = 15 ppm/K) bzw. Aluminium (CTE = 23 ppm/K) gegenüber der Kunststoffumspritzungsmasse (CTE (PA 66) = 18-65 ppm/K, je nach Richtung der Faserorientierung) bilden.

Für die Drahtbondverbindungen 19 können beispielsweise Aluminium-Bonddrähte mit einem Durchmesser von etwa 20 - 400 µm verwendet werden, solange Stromstärken im Bereich von typischerweise 2 A maximal liegen. Bei höheren Stromstärken können parallel mehrere Drahtbondverbindungen 19 vorgesehen werden oder, alternativ, echte Hochstrom-Bändchen-Bonds eingesetzt werden, wodurch Stromstärken von beispielsweise bis zu 100 A geleitet werden können.

Die hierin vorgestellte Stanzgitteranordnung 1 kann sehr gut resistent gegen chemisch aggressive Medien sein, da die darin vorgesehenen Leiterbahnen, insbesondere darin vorgesehene kupferhaltige Leiterbahnen 11, durch die hermetisch dicht verkapselnde Vergussmasse 13 sehr gut gegen einen Kontakt mit solchen Medien geschützt sind. Insbesondere blank liegende, das heißt nicht von einer korrosionshemmenden Schicht wie zum Beispiel einer Zinnschicht geschützte Bereiche von kupferhaltigen Leiterbahnen 11 sind durch die Verkapselung gut geschützt und insbesondere von blank liegenden Bereichen der aluminiumhaltigen Leiterbahnen 9 so weit entfernt, dass keine wesentliche lonenwanderung in einem Elektrolyten erfolgen kann und somit auch ein elektrochemischer Angriff aggressiver Medien weitgehend verhindert wird. Die Stanzgitteranordnung 1 kann ferner kostengünstig gefertigt werden und/oder weist ein geringes Gewicht auf, da sie in überwiegenden Teilen von dem ersten Stanzgitter, das heißt dem Aluminium-Stanzgitter 3, gebildet wird. Eine Zweitumspritzung der Stanzgitter 3, 5 mit Kunststoffumspritzungsmasse 23, 25 kann verhältnismäßig einfach ausgestaltet werden, da Elektrolyt generell entlang des gesamten Aluminium-Stanzgitters inklusive dessen Freistanzungen eindringen darf, ohne leitende Korrosionsprodukte zu erzeugen. Statt aufwendiger Sonderprozesse wie beispielsweise Kupfer-Aluminium-Schweißen können Standardprozesse wie Kupfer-Aluminium-Wire-Bonden eingesetzt werden. Es brauchen vorab keine aufwendigen Behandlungen des Aluminiums, wie zum Beispiel ein Abbeizen von Oxidschichten, durchgeführt werden.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Stanzgitteranordnung (1) für ein Getriebesteuermodul (100), aufweisend:
ein erstes Stanzgitter (3) mit aluminiumhaltigen Leiterbahnen (9),
ein zweites Stanzgitter (5) mit kupferhaltigen Leiterbahnen (11),
wobei Leiterbahnen (9) des ersten Stanzgitters (3) mit Leiterbahnen (11) des zweiten Stanzgitters (5) elektrisch verbunden sind,
**dadurch gekennzeichnet, dass**
Leiterbahnen (9) des ersten Stanzgitters (3) mit Leiterbahnen (11) des zweiten Stanzgitters (5) jeweils mittels einer Drahtbondverbindung (19) elektrisch verbunden sind und
Verbindungsbereiche (7), in denen jeweils eine aluminiumhaltige Leiterbahn (9) des ersten Stanzgitters (3) mit einer kupferhaltigen Leiterbahn (11) des zweiten Stanzgitters (5) mittels einer der Drahtbondverbindungen (19) verbunden ist, mittels einer Vergussmasse (13) hermetisch dicht verkapselt sind.

2. Stanzgitteranordnung nach Anspruch 1, wobei die Vergussmasse (13) eine Epoxidharzmasse, eine Polyurethanmasse oder eine Acrylatmasse ist.

3. Stanzgitteranordnung nach einem der vorangehenden Ansprüche, wobei die Vergussmasse (13) die Drahtbondverbindungen (19) vollständig umschließt.

4. Stanzgitteranordnung nach einem der vorangehenden Ansprüche, wobei die kupferhaltigen Leiterbahnen (11) des zweiten Stanzgitters (5) zumindest außerhalb der Verbindungsbereiche (7) vollständig mit einer korrosionshemmenden Schicht, insbesondere einer Zinnschicht, beschichtet sind.

5. Stanzgitteranordnung nach einem der vorangehenden Ansprüche, wobei ein Abstand zwischen nicht von der Vergussmasse (13) bedeckten freiliegenden Bereichen von aluminiumhaltigen Leiterbahnen (9) des ersten Stanzgitters (3) und nicht von der Vergussmasse (13) bedeckten freiliegenden Bereichen von kupferhaltigen Leiterbahnen (11) des zweiten Stanzgitters (5) wenigstens 0,5 cm beträgt.

6. Stanzgitteranordnung nach einem der vorangehenden Ansprüche, wobei ein Abstand zwischen nicht von der Vergussmasse (13) bedeckten freiliegenden Bereichen von aluminiumhaltigen Leiterbahnen (9) des ersten Stanzgitters (3) und nicht von der Vergussmasse (13) bedeckten sowie nicht mit einer korrosionshemmenden Schicht beschichteten ungeschützten Bereichen von kupferhaltigen Leiterbahnen (11) des zweiten Stanzgitters (5) wenigstens 0,5 cm beträgt.

7. Stanzgitteranordnung nach einem der vorangehenden Ansprüche, wobei eine aluminiumhaltige Leiterbahn (9) des ersten Stanzgitters (3) von einer kupferhaltigen Leiterbahn (11) des zweiten Stanzgitters (5) in dem Verbindungsbereich (7) über einen Spalt (27) beabstandet ist und der Spalt (27) mit Vergussmasse (13) gefüllt ist.

8. Stanzgitteranordnung nach einem der vorangehenden Ansprüche, wobei das erste Stanzgitter (3) und/oder das zweite Stanzgitter (5) zumindest bereichsweise mit einer Kunststoffumspritzungsmasse (23, 25), insbesondere mit Polyamid, umspritzt ist.

9. Stanzgitteranordnung nach Anspruch 8, wobei die Kunststoffumspritzungsmasse (23, 25) mit dem jeweiligen Stanzgitter (3, 5) in formschlüssigem Eingriff steht.

10. Getriebesteuermodul (100) aufweisend eine Stanzgitteranordnung (1) gemäß einem der Ansprüche 1 bis 9.

11. Verfahren zum Fertigen einer Stanzgitteranordnung (1) für ein Getriebesteuermodul (100), insbesondere einer Stanzgitteranordnung (1) gemäß einem der Ansprüche 1 bis 9, aufweisend zumindest die folgenden Verfahrensschritte:
Bereitstellen eines ersten Stanzgitters (3) mit aluminiumhaltigen Leiterbahnen (9) und eines zweiten Stanzgitters (5) mit kupferhaltigen Leiterbahnen (11);
elektrisches Verbinden von Leiterbahnen (9) des ersten Stanzgitters (3) mit Leiterbahnen (11) des zweiten Stanzgitters (5) jeweils durch Drahtbonden;
und
hermetisch dichtes Verkapseln von Verbindungsbereichen (7), in denen jeweils eine aluminiumhaltige Leiterbahn (9) des ersten Stanzgitters (3) mit einer kupferhaltigen Leiterbahn (11) des zweiten Stanzgitters (5) mittels einer der Drahtbondverbindungen (19) verbunden ist, durch Aufbringen einer Vergussmasse (13).

12. Verfahren nach Anspruch 11, wobei die Vergussmasse (13) auf die Verbindungsbereiche (7) durch Dispensen, Vergießen, Spritzen oder Molden aufgebracht wird.

## Claims

1. Stamped grid arrangement (1) for a transmission control module (100), comprising:
a first stamped grid (3) with aluminium-containing conductor paths (9),
a second stamped grid (5) with copper-containing conductor paths (11),
wherein conductor paths (9) of the first stamped grid (3) are electrically connected to conductor paths (11) of the second stamped grid (5),
**characterized in that**
conductor paths (9) of the first stamped grid (3) are electrically connected to conductor paths (11) of the second stamped grid (5) respectively by means of a wire bonding connection (19) and
connection regions (7), in which an aluminium-containing conductor path (9) of the first stamped grid (3) is respectively connected to a copper-containing conductor path (11) of the second stamped grid (5) by means of one of the wire bonding connections (19), are encapsulated in a hermetically sealed manner by means of a potting compound (13).

2. Stamped grid arrangement according to Claim 1, wherein the potting compound (13) is an epoxy resin compound, a polyurethane compound or an acrylate compound.

3. Stamped grid arrangement according to one of the preceding claims, wherein the potting compound (13) completely encloses the wire bonding connections (19) .

4. Stamped grid arrangement according to one of the preceding claims, wherein the copper-containing conductor paths (11) of the second stamped grid (5) are completely coated with a corrosion-inhibiting layer, in particular a tin layer, at least outside the connection regions (7).

5. Stamped grid arrangement according to one of the preceding claims, wherein a distance between exposed regions of aluminium-containing conductor paths (9) of the first stamped grid (3) that are not covered by the potting compound (13) and exposed regions of copper-containing conductor paths (11) of the second stamped grid (5) that are not covered by the potting compound (13) is at least 0.5 cm.

6. Stamped grid arrangement according to one of the preceding claims, wherein a distance between exposed regions of aluminium-containing conductor paths (9) of the first stamped grid (3) that are not covered by the potting compound (13) and unprotected regions of copper-containing conductor paths (11) of the second stamped grid (5) that are not covered by the potting compound (13) and are not coated with a corrosion-inhibiting layer is at least 0.5 cm.

7. Stamped grid arrangement according to one of the preceding claims, wherein an aluminium-containing conductor path (9) of the first stamped grid (3) is kept at a distance from a copper-containing conductor path (11) of the second stamped grid (5) in the connection region (7) by way of a gap (27) and the gap (27) is filled with potting compound (13).

8. Stamped grid arrangement according to one of the preceding claims, wherein the first stamped grid (3) and/or the second stamped grid (5) is overmoulded at least in certain regions with a plastics overmoulding compound (23, 25), in particular with polyamide.

9. Stamped grid arrangement according to Claim 8, wherein the plastics overmoulding compound (23, 25) is in form-fitting engagement with the respective stamped grid (3, 5).

10. Transmission control module (100) comprising a stamped grid arrangement (1) according to one of Claims 1 to 9.

11. Method for producing a stamped grid arrangement (1) for a transmission control module (100), in particular a stamped grid arrangement (1) according to one of Claims 1 to 9, comprising at least the following method steps:
providing a first stamped grid (3) with aluminium-containing conductor paths (9) and a second stamped grid (5) with copper-containing conductor paths (11); electrically connecting conductor paths (9) of the first stamped grid (3) to conductor paths (11) of the second stamped grid (5) respectively by wire bonding; and
encapsulating in a hermetically sealed manner connection regions (7) in which an aluminium-containing conductor track (9) of the first stamped grid (3) is respectively connected to a copper-containing conductor path (11) of the second stamped grid (5) by means of one of the wire bonding connections (19), by applying a potting compound (13) .

12. Method according to Claim 11, wherein the potting compound (13) is applied to the connection regions (7) by dispensing, pouring, spraying or moulding.

## Revendications

1. Ensemble de grilles estampées (1) destiné à un module de commande de transmission (100), comportant :
une première grille estampée (3) pourvue de pistes conductrices contenant de l'aluminium (9),
une deuxième grille estampée (5) pourvue de pistes conductrices contenant du cuivre (11),
des pistes conductrices (9) de la première grille estampée (3) étant reliées électriquement à des pistes conductrices (11) de la deuxième grille estampée (5),
**caractérisé en ce que**
des pistes conductrices (9) de la première grille estampée (3) sont reliées électriquement à des pistes conductrices (11) de la deuxième grille estampée (5) respectivement au moyen d'une liaison filaire soudée (19), et
des zones de liaison (7), dans lesquelles respectivement une piste conductrice contenant de l'aluminium (9) de la première grille estampée (3) est reliée à une piste conductrice contenant du cuivre (11) de la deuxième grille estampée (5) au moyen d'une liaison filaire soudée (19), sont encapsulées de manière hermétiquement étanche au moyen d'une masse d'enrobage (13).

2. Ensemble de grilles estampées selon la revendication 1, dans lequel la masse d'enrobage (13) est une masse de résine époxyde, une masse de polyuréthane ou une masse d'acrylate.

3. Ensemble de grilles estampées selon l'une quelconque des revendications précédentes, dans lequel la masse d'enrobage (13) entoure complètement les liaisons filaires soudées (19).

4. Ensemble de grilles estampées selon l'une quelconque des revendications précédentes, dans lequel les pistes conductrices contenant du cuivre (11) de la deuxième grille estampée (5), au moins en dehors des zones de liaison (7), sont recouvertes complètement d'une couche anticorrosive, en particulier d'une couche d'étain.

5. Ensemble de grilles estampées selon l'une quelconque des revendications précédentes, dans lequel une distance entre des zones exposées, non recouvertes par la masse d'enrobage (13), des pistes conductrices contenant de l'aluminium (9) de la première grille estampée (3), et des zones exposées, non recouvertes par la masse d'enrobage (13), des pistes conductrices contenant du cuivre (11) de la deuxième grille estampée (5), mesure au moins 0,5 cm.

6. Ensemble de grilles estampées selon l'une quelconque des revendications précédentes, dans lequel une distance entre des zones exposées, non recouvertes par la masse d'enrobage (13), des pistes conductrices contenant de l'aluminium (9) de la première grille estampée (3), et des zones exposées, non recouvertes par la masse d'enrobage (13), des pistes conductrices contenant du cuivre (11) de la deuxième grille estampée (5), mesure au moins 0,5 cm.

7. Ensemble de grilles estampées selon l'une quelconque des revendications précédentes, dans lequel une piste conductrice contenant de l'aluminium (9) de la première grille estampée (3) est espacée d'une piste conductrice contenant du cuivre (11) de la deuxième grille estampée (5) dans la zone de liaison (7) à travers un intervalle (27), et l'intervalle (27) est rempli de masse d'enrobage (13).

8. Ensemble de grilles estampées selon l'une quelconque des revendications précédentes, dans lequel la première grille estampée (3) et/ou la deuxième grille estampée (5) est/sont enrobée(s) au moins par endroits par une masse d'enrobage plastique (23, 25), en particulier du polyamide.

9. Ensemble de grilles estampées selon la revendication 8, dans lequel la masse d'enrobage plastique (23, 25) est en prise par complémentarité de formes avec la grille estampée (3, 5) respective.

10. Module de commande de transmission (100), comportant un ensemble de grilles estampées (1) selon l'une quelconque des revendications 1 à 9.

11. Procédé de fabrication d'un ensemble de grilles estampées (1) destiné à un module de commande de transmission (100), en particulier d'un ensemble de grilles estampées (1) selon l'une quelconque des revendications 1 à 9, comportant au moins les étapes de procédé suivantes consistant à :
prévoir une première grille estampée (3) pourvue de pistes conductrices contenant de l'aluminium (9) et une deuxième grille estampée (5) pourvue de pistes conductrices contenant du cuivre (11) ;
relier électriquement des pistes conductrices (9) de la première grille estampée (3) à des pistes conductrices (11) de la deuxième grille estampée (5) respectivement par liaison filaire ; et
encapsuler de manière hermétiquement étanche, par application d'une masse d'enrobage (13), des zones de liaison (7) dans lesquelles respectivement une piste conductrice contenant de l'aluminium (9) de la première grille estampée (3) est reliée à une piste conductrice contenant du cuivre (11) de la deuxième grille estampée (5) au moyen d'une liaison filaire soudée (19).

12. Procédé selon la revendication 11, dans lequel la masse d'enrobage (13) est appliquée sur les zones de liaison (7) par distribution, coulage, injection ou moulage.
